# EUROPEAN PATENT SPECIFICATION

(11) **EP 1 605 220 B1**
(45) Date of publication and mention of the grant of the patent: **11.11.2009**
(21) Application number: 04712166.0
(22) Date of filing: 18.02.2004
(51) Int. Cl.: F28D 15/02, H01S 3/094, H01S 5/024, H01L 23/46

(54) **HEAT SUNK, LASER MODULE, LASER DEVICE, AND LASER-PROCESSING DEVICE**
WÄRMEABLEITER, LASERMODUL, LASER-VORRICHTUNG UND LASER-VERARBEITUNGSVORRICHTUNG
DISSIPATEUR THERMIQUE, MODULE LASER, DISPOSITIF LASER ET DISPOSITIF DE TRAITEMENT LASER

(30) Priority: 27.02.2003 JP 2003052039
(43) Date of publication of application: 14.12.2005
(73) Proprietor: Laserfront Technologies, Inc., Kanagawa 229-1198 (JP)
(72) Inventor: KOUTA, Hikaru, c/o NEC CORPORATION, Minato-ku, Tokyo 108-8001 (JP); TAKAHASHI, Hisaya, c/o NEC CORPORATION, Minato-ku, Tokyo 108-8001 (JP); MIKUBO, Kazuyuki, c/o NEC CORPORATION, Minato-ku, Tokyo 108-8001 (JP); ONO, Hideyuki, c/o NEC CORPORATION, Minato-ku, Tokyo 108-8001 (JP); TUNEKANE, Masaki, c/o NEC CORPORATION, Minato-ku, Tokyo 108-8001 (JP); ISHIDA, Toshinori, c/o NEC CORPORATION, Minato-ku, Tokyo 108-8001 (JP); KUBOTA, Keiichi, c/o NEC CORPORATION, Minato-ku, Tokyo 108-8001 (JP)
(74) Representative: Glawe, Delfs, Moll
(86) International application number: PCT/JP2004/001782
(87) International publication number: WO 2004/076952

(56) References cited:
- JP-A- 10 070 222
- JP-A- 10 111 089
- JP-A- 10 209 531
- JP-A- 2001 257 492
- JP-A- 2003 008 273
- JP-A- 2003 047 258

## Description

### Technical Field

The present invention relates to a heat sink as defined in the preamble of claim 1 for cooling off a heating element by causing a refrigerant to flow, a laser module, a laser apparatus and a laser processing apparatus, and in particular, to a heat sink, a laser module, a laser apparatus and a laser processing apparatus suitable for cooling off a laser diode. Such a heat sink is known for instance from JP 2003-47258.

### Background Art

In a laser diode that is used as a pumping source for Nd:YAG laser or as a light source for direct processing therewith, the conversion efficiency from electricity to light is 50% or so. Where the laser diode is used as a light source for Nd:YAG laser, heat equivalent to the output of laser light is generated. Generally, since a laser diode causes a problem of a lowering in durability and conversion efficiency as the temperature increases, an increase in temperature is suppressed by attaching a heat sink having high cooling capacity. Also, in recent years, a laser having high output has been demanded for welding of metals and machining thereof. In line therewith, high output of a laser diode has been advanced, and such a laser diode has been developed, in which an active area where a laser beam is generated is formed like an array in the lateral direction. The size of such a laser diode array is usually 10mm in width and 1.0 through 1.5mm in the resonator length, and 100 through 150µm in thickness, and also the output is 20 through 60W or so. Since the wavelength of a laser beam outputted from the laser diode array changes according to the temperature, it is necessary that the temperature in the lateral direction is kept constant in order to generate light of a further uniform wavelength. Also, it is preferable that the laser diodes are cooled off to a further low temperature in order to prolong the service life of the laser diodes.

Therefore, a heat sink by which a high-output laser diode array is efficiently cooled off to a uniform temperature has been examined. Such a heat sink in which a refrigerant is caused to flow is used as a heat sink for the laser diode array, and for example, a heat sink has been proposed, in which two flow channels having, respectively, independent inlet ports and outlet ports on the same plane are provided. (For example, refer to Japanese Unexamined Patent Publication No. Hei-8-139478 (Pages 2 and 3 and FIG. 1)(**Patent Document 1)**). The heat sink improves the thermal conversion efficiency and a temperature uniformity of a lower area of the plane contacted with the laser diode array by forming a bent portion in a flow channel in the lower area.

In addition, such a heat sink has been proposed, in which channels into which a refrigerant flows are structured to be vertically two-layered by stacking three to five heat radiating plates made of a metallic material having high heat conductivity and joining the same to each other (For example, refer to United States Patent No. 5105429 **(Patent Document 2),** United States Patent No. 5105430 **(Patent Document 3),** and German Unexamined Patent Publication No. 4315580 **(Patent Document 4)).** The flow channels formed vertically two-layered are connected with each other by means of a plurality of holes or micro-channels, which are formed at the lower area of a plane contacted with a laser diode array, and are made into a single flow channel. Further, another heat sink has been proposed, which has a two-layered flow channel by which a refrigerant is supplied from the flow channel positioned at the lower part thereof and the refrigerant is discharged from the flow channel positioned at the upper part thereof, and is structured so that a refrigerant is ejected from the flow channel positioned at the lower part to the flow channel positioned at the upper part in an area contacted with a laser diode array (For example, refer to Japanese Unexamined Patent Publication No. Hei-8-139479, Pages 2 and 3, and FIG. 1 and FIG. 2 **(Patent Document 5))**

In the heat sink having above-described stacking structure, a heat sink having such a structure has been proposed, in which a refrigerant injected from an inlet port is separated into a plurality of flow channels and is led to the lower part area of the plane contacted with a laser diode array through said flow channels at a uniform temperature and a uniform flow rate, and is further led into a plurality of flow channels formed on the upper-layered heat radiating plate via flow channels formed in said lower part area and communicating the upper- and lower-layered flow channels in the vertical direction, and is further led from the upper-layered flow channels to the discharge outlet (For example, refer to Japanese Unexamined Patent Publication No. Hei-10-209531 **(Patent Document 6)).** In the prior arts, such a method has been proposed, which forms flow channels by means of chemical etching. Also, still another heat sink has been proposed, which is provided with fins for leading a refrigerant supplied from the input inlet to vertically connected flow channels under uniform pressure (For example, refer to International Publication No. 00/11922 Pamphlet, Pages 5 through 7, FIGS. 2A through 2C **(Patent Document 7)).** Still further, such a heat sink has been proposed, which is provided with an intermediate layer to solve problems of a pressure loss and a lowering in flow rates resulted from stacking of respective heat radiating plates (For example, refer to Japanese Unexamined Patent Publication No. 2001-160649, Pages 3 through 5, and FIG. 1 **(Patent Document 8))**

However, demand for high output lasers have increased, and the number of laser diodes used therefor has been increased. Cost reduction and high reliability have been required with respect to heat sinks for cooling off the laser diodes. However, the prior art heat sinks have the following problems and shortcomings.

Since, in flow channels in the conventional heat sinks, the direction of flow of a refrigerant is radically changed, and the diameter thereof is radically made thin, there is a problem in that the pressure loss is great when the refrigerant flows in the flow channels. In particular, in micro-channels, micro-slits, or a capillary tubing array of the flow channels used for vertical communication of the two-layered structure, the pressure loss of the refrigerant is increased. If the pressure loss of the refrigerant is large, the load of the pressure applied into the flow channels is accordingly increased. Therefore, a possibility of refrigerant leakage is increased. In addition, in applications using a plurality of heat sinks, since a high performance pump for sending out a refrigerant is required, the costs thereof are increased. Further, if the shape of the flow channels is complicated, the flow velocity is made slow at portions where the flow channel is widened in width and is bifurcated into several flow channels, and there is another problem in that the cooling capacity is lowered. Although there is means for improving the flow velocity by thinning the flow channel, the pressure loss is increased as described above. Further, in a flow channel having a complicated shape, which is provided with bifurcated and confluent portions, it is not preferable that there is a danger of a refrigerant leaking out due to joining defectives at the joining surfaces of the respective layers, and the design thereof is complicated.

Still further, a majority of the prior art heat sinks have a lamination structure having flow channels for flowing a refrigerant in the upper layer, the lower layer and in the intermediate layer disposed therebetween. When producing a heat sink of the lamination structure, since it is necessary that three to five heat radiating plates are stacked and jointed together, the costs thereof are further increased in comparison with a mono-layered structure. However, if the flow channel is formed of a mono-layered structure, no heat sink having a sufficient cooling capacity is obtainable. Therefore, Patent Document 1 has proposed a heat sink having two independent bent flow channels on the same plane, wherein since the heat sink is provided with an inlet port and an outlet port, respectively, means for supplying a refrigerant is complicated. Also, since the flow channel is bent, there is a problem in that the pressure loss of a **refrigerant** is increased.

Further, where water is used as a refrigerant, there is another problem in that corrosion occurs in the flow channel. Where a heat sink is formed of a metallic material, mixture of oxygen in water that is a refrigerant causes corrosion. Also, where a heat sink is concurrently used as an electrode for driving a heating element, a large current is flown into the heat sink, wherein durability is required for galvanic corrosion. However, it is a fact that no consideration is taken for any corrosion in the conventional heat sinks.

### Disclosure of the Invention

It is therefore an object of the present invention to provide a heat sink, a laser module, a laser apparatus and a laser processing apparatus, which can be produced at low cost and have excellent heat efficiency and reliability.

A heat sink according to a first aspect of the invention is a heat sink constructed by stacking two heat radiating plates, wherein one heat radiating plate includes a refrigerant flow channel composed of a recess portion or a groove formed on an overlapping plane with the other heat radiating plate and a singular or a plurality of projections provided so as to be dispersed in a specified area of the refrigerant flow channel; and at least one of the two heat radiating plates is provided with a pair of openings that become an inlet port of a refrigerant and an outlet port thereof, wherein flows of the refrigerant are disturbed by the projections as defined in claim 1.

In the invention, turbulent flows are brought about in flows of the refrigerant flowing in the flow channels by the refrigerant being brought into contact with the projections. If a turbulent flow occurs in the flow of the refrigerant, mixture of the refrigerant is carried out by vortex motions, and transfer of heat from the heat radiating plate to the refrigerant is accelerated, wherein the cooling capacity thereof is increased in comparison with a laminar flow. In addition, since the heat sink according to the present invention is composed of two heat radiating plates, there are few joining portions, wherein the ratio of generation of refrigerant leakage due to joining defectives can be reduced, and it is possible to reduce the production costs thereof.

The specified area is provided at a position adjusted to an area to which a heating element to be cooled off is thermally connected.

The cross sectional plane of the projections is gradually made smaller from the bottom surface of the flow channel upward or from the upper surface of the flow channel downward. In the present invention, by gradually making the cross sectional plane of the projections smaller toward the upper surface of the flow channel or toward the bottom surface thereof, an effect of a refrigerant flowing in the flow channel being agitated in the up and down direction can be brought about, wherein a cooling effect can be improved.

A part of the outer edge of the cross sectional plane of the projection is formed to be curved. Further, it is preferable that the shape of the cross sectional plane of the projections is circular, elliptical or streamline-shaped to the flows of the **refrigerant**. In the present invention, by making the shape of the projections circular, elliptical or streamline-shaped to the flows of the **refrigerant**, it is possible to further suppress the pressure loss resulting from turbulent flows brought about by the projections in comparison with a case where the cross sectional plane is rectangular or polygonal.

It is preferable that the projections are contacted with the other heat radiating plate. In the present invention, by bringing the projections into contact with the other heat radiating plate, it becomes possible for the two heat radiating plates to diffuse heat via the projections, and an agitating effect of the refrigerant can be improved, wherein the cooling effect can be improved.

It is preferable that one heat radiating plate described above has a pair of flow channels shaped so that, after a refrigerant introduced from the inlet port is divided into the flow channels and passes through the specified area, the refrigerant is discharged from the outlet port, and the specified area is provided with a separation member for preventing the refrigerant from confluence with each other. In the present invention, by providing the separation member, it is possible to prevent the heat conversion efficiency from being lowered due to mixing of refrigerant, which is heated by the heating element, in the specified area.

It is preferable that the flow channel includes the first area contacted with the inlet port and the second area between the first area and the specified area, and the width of the second area is narrower than that of the first area. In the present invention, by making the width of the flow channel contacted with the specified area narrower than that of the flow channel in the upstream thereof, it is possible to accelerate the velocity of the refrigerant flowing into the specified area, wherein it is possible to improve the cooling efficiency.

It is preferable that at least a part of the inner surface of the flow channel is formed to be curved. In the invention, since the inner surface of the flow channel is formed to be curved, turbulent flows generated outside the specified area can be suppressed, and it is possible to prevent the velocity from being lowered and to prevent a pressure loss.

A refrigerant flow channel having the same pattern as at least a part of the refrigerant flow channel formed in one heat radiating plate described above may be formed on the other heat radiating plate, so that the sectional area of the flow channel is increased, and the pressure loss of the flow channel can be reduced, thereby the cooling efficiency can be improved.

In addition, it is preferable that the flow channels are formed by a chemical etching method. In the present invention, if the chemical etching method is employed, for example, masking is given to the heat radiating plates and the heat radiating plates are immersed in an etching solution. Thereby, it is possible to form flow channels having the same depth at one time. As a result, it becomes easy to facilitate curving of the inner surface of the flow channels.

It is preferable that the heat radiating plates are made of copper or a copper alloy, and a nickel-contained layer including nickel at a ratio of 70wt% or more is formed on the surface with which the refrigerant in the flow channel is brought into contact. In the present invention, by forming the nickel layer, it is possible to prevent the heat radiating plates from corroding, and the reliability thereof can be improved. Further, it is possible to form the nickel-contained layer by a plating method.

If the heat radiating plates are made of copper or a copper alloy, and a copper oxide layer having a thickness of 50nm or more is formed on the surface with which the refrigerant in the flow channel is brought into contact, the heat radiating plates can be prevented from corroding, and the reliability thereof can be improved. Still further, the copper-oxidized layer may be formed by heating the heat sink in an atmosphere including oxygen.

The heating element is, for example, a laser diode.

A laser module according to a second aspect of the present invention includes the heat sink, a setting fixture fixed on the heat sink, and a laser diode fixed on one heat radiating plate of the heat sink. In the present invention, by employing the heat sink having few joining portions, the ratio of generation of refrigerant leakage can be reduced, and it is possible to produce a laser module having high reliability at low cost.

It is preferable that the laser module includes a singular or a plurality of heat sinks, a through-hole penetrating through a singular or a plurality of heat sinks is formed at an area having no flow channel formed in the heat sinks, and, the heat sink is fixed at the setting fixture by a screw inserted into the through-hole and screwed in the setting fixture.

Also, it is preferable that a flow channel by which a refrigerant is supplied to the heat sink is formed in the setting fixture.

A laser apparatus according to a third aspect of the present invention includes the laser module and a laser rod which is excited by laser light oscillated by the laser module and oscillates laser light. In the present invention, it is possible to produce a laser apparatus having high reliability at low cost by employing the laser module.

A laser processing apparatus according to a fourth aspect of the present invention includes the laser module. In the present invention, it is possible to produce a laser processing apparatus having high reliability by employing the laser module.

A laser processing apparatus according to a fifth aspect of the present invention includes the laser apparatus. In the present invention, by employing the laser apparatus, it is possible to stably cool off the laser diode for a longer period of time, wherein the running costs thereof can be reduced.

### Brief Description of the Drawings

FIG. 1(a) is a plan view showing the first heat radiating plate of a heat sink according to a first embodiment of the present invention, and FIG. 1(b) is a plan view showing the second heat radiating plate;
FIG. 2 is a perspective view showing a heat sink according to the first embodiment of the present invention;
FIG. 3 is a sectional view taken along the line A-A in FIG. 2;
FIG. 4 is a sectional view showing projections formed on the first heat radiating plate of a heat sink according to the first embodiment of the present invention;
FIGS. 5(a) through 5(c) are sectional views showing the shapes of the projections formed on the first heat radiating plate of a heat sink according to the first embodiment of the present invention, which correspond to the sectional view taken along the line B-B in FIG. 4;
FIG. 6 is a plan view showing a first modified version of a heat sink according to the present invention;
FIG. 7 is a plan view showing a second modified version of a heat sink according to the present invention;
FIG. 8 is a plan view showing a third modified version of a heat sink according to the present invention;
FIG. 9 is a plan view showing a fourth modified version of a heat sink according to the present invention;
FIG. 10(a) is a plan view showing the first heat radiating plate according to a second embodiment of the present invention, and FIG.10(b) is a plan view showing the second heat radiating plate;
FIG. 11 is a perspective view showing a heat sink according to second embodiment of the present invention;
FIG. 12(a) is plan view showing the first heat radiating plate of a heat sink according to third embodiment of the present invention; and FIG. 12(b) is a plan view showing the second heat radiating plate;
FIG. 13 is a perspective view showing a heat sink according to the third embodiment of the present invention;
FIG. 14 is a perspective view showing the configuration in a case where heat sinks according to the third embodiment of the present invention are stacked in the longitudinal direction;
FIG. 15 is a perspective view showing the configuration in a case where heat sinks according to the third embodiment of the present invention are stacked in five layers;
FIG. 16 is a sectional view showing a laser module according to a fourth embodiment of the present invention;
FIG. 17 is a schematic view showing the configuration of a laser apparatus according to a fifth embodiment of the present invention;
FIG. 18 is a schematic view showing the configuration of a laser processing apparatus according to a sixth embodiment of the present invention;
FIG. 19 is a sectional view showing projections formed in the heat sink according to the first embodiment of the present invention;
FIG. 20 is a perspective view showing the configuration of a prior art heat sink proposed in Patent Document 7;
FIG. 21 is a perspective view showing the configuration of a prior art heat sink proposed in Patent Document 8;
FIG. 22(a) is a sectional view showing a prior art heat sink proposed in Patent Document 4, and FIG. 22(b) is a sectional view taken along the line A-A thereof; and
FIG. 23 is a plan view showing a case where flow channels are formed in the second heat radiating plate of a heat sink according to the first embodiment of the present invention.

### Best Mode for Carrying Out the Present invention

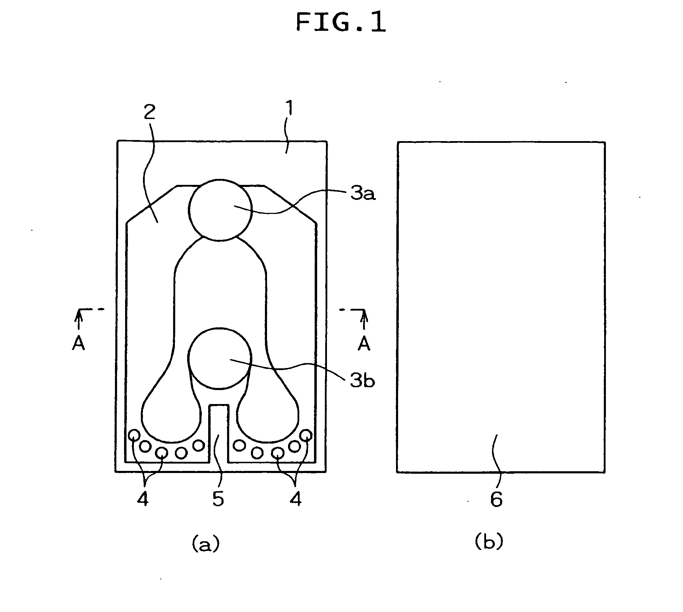

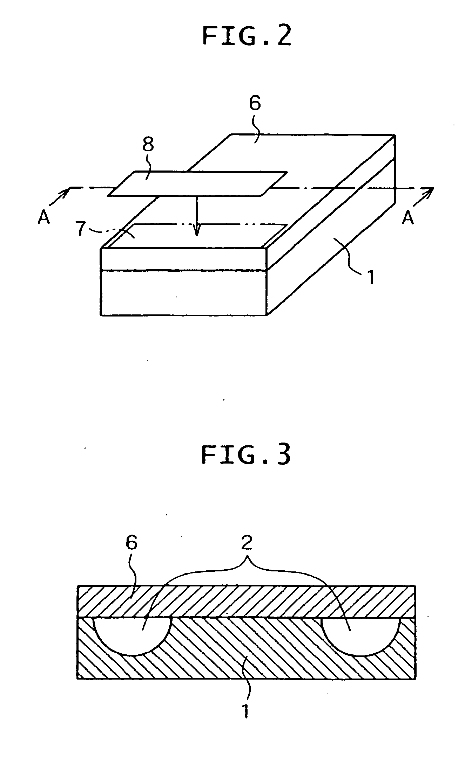

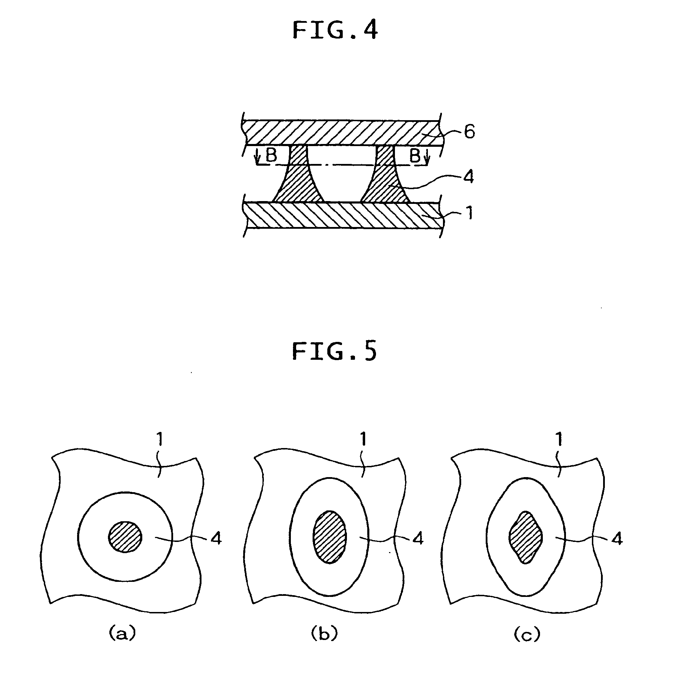

Hereinafter, a detailed description is given of heat sinks according to embodiments of the present invention with reference to the accompanying drawings. First, a description is given of a heat sink according to first embodiment of the present invention. FIG. 1(a) is a plan view showing the first heat radiating plate of a heat sink according to a first embodiment of the present invention, and FIG. 1(b) is a plan view showing the second heat radiating plate thereof. Also, FIG. 2 is a perspective view showing a heat sink according to first embodiment of the present invention. FIG. 3 is a sectional view taken along the line A-A shown in FIG. 1(a) and FIG. 2. Further, FIG. 4 is sectional view showing the shapes of projections formed in the heat sink according to first embodiment of the present invention. FIG. 5A through 5C are sectional views taken along the line B-B shown in FIG. 4. As shown in FIGS. 1(a) and 1(b), a heat sink according to first embodiment of the present invention includes a first heat radiating plate 1 having a flow channel 2, in which a refrigerant flows, formed therein, and a second heat radiating plate 6 jointed to the first heat radiating plate 1. The second heat radiating plate 6 is plate-shaped, and no flow channel is formed therein.

In the first heat radiating plate 1, two opening portions 3a and 3b which are made into an inlet port for injecting a refrigerant and an outlet port for discharging a refrigerant are formed at portions separated in the lengthwise direction of the first heat radiating plate 1. Also, a pair of flow channels 2 are formed from the opening portion 3a toward the opening portion 3b in the first heat radiating plate 1. The flow channels 2 are formed so as to be deviated from the opening portion 3a toward the long side of the first heat radiating plate 1, respectively, and extend toward the opening portion 3b along the long side of the first heat radiating plate 1, and reach the opening portion 3b, turning around in the vicinity of the short side of the first heat radiating plate 1. The flow channels 2 have a groove-like shape, the section of which is semicircular, as shown in FIG. 3.

Further, five projections 4 are provided at the left and right sides, respectively, in the vicinity of the turning-around portion of the flow channels 2. It is preferable that the sections of the projections 4 in the vertical direction with respect to the second heat radiating plate 6 and the first heat radiating plate 1 are made narrower and narrower from the first heat radiating plate 1 side toward the second heat radiating plate 6 side as shown in FIG. 4. The sections (the sections taken along the line B-B in FIG. 4) of the projections 4 in the parallel direction with respect to the second heat radiating plate 6 and the first heat radiating plate 1 are, for example, circular (Refer to FIG. 5(a)), elliptical (Refer to FIG. 5(b)), or streamline-shaped (Refer to FIG. 5(c)). Further, in the first heat radiating plate 1, a separation rod 5 is provided, which extends in the lengthwise direction of the first heat radiating plate 1 from the middle part of the short side at the opening portion 3b side of the first heat radiating plate 1.

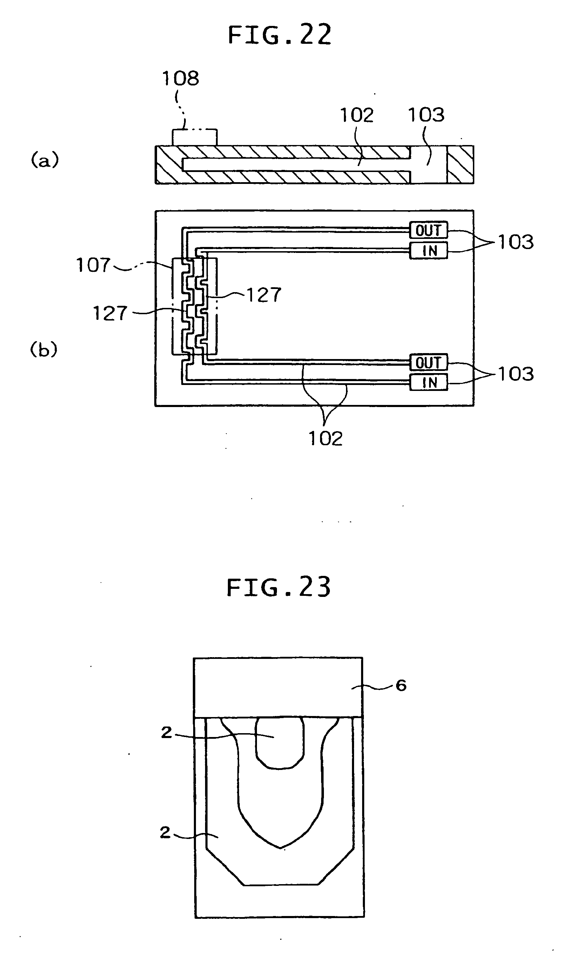

Still further, a pattern whose shape is similar to the flow channel 2 formed in the first heat radiating plate 1 may be formed on the second heat radiating plate 6 as shown in FIG. 23.

Next, a description is given of a method for producing a heat sink according to the present embodiment. A material of the heat radiating plate 1 and the heat radiating plate **6,** which compose a heat sink according to the embodiment, is a plate-shaped metallic material such as copper, which has high thermal conductivity, and flow channels 2, projections 4 and separation rod 5, etc., are formed on the metallic plate. The metallic plate is made into the first heat radiating plate 1. With respect to a method for forming these elements, for example, after a copper plate is masked to the shapes of the flow channels 2, projections 4 and the separation rod 5, an isotropic chemical etching method is applicable. Next, the second heat radiating plate 6 shown in FIG. 1(b) is jointed on the upper part of the first heat radiating plate 1 shown in FIG. 1(a), and a heat sink shown in FIG. 2 is assembled.

Next, a description is given of operations of the heat sink according to the present embodiment, which is constructed as described above. In the heat sink according to the embodiment, a heating element 8 such as a laser diode array, etc., is jointed at the position of the heating element jointed portion 7 of the second heat radiating plate 6. The heating element jointed portion 7 is adjusted to an area where the projections 4 on the first heat radiating plate 1 are formed. Also, when cooling off the heating element 8, for example, the opening portion 3a is made into an inlet port and the opening portion 3b is made into an outlet port, wherein a refrigerant such as water is injected from the opening portion 3a. The injected refrigerant is divided into the left side and the right side and is flown into the flow channels 2. The velocity thereof is accelerated at a portion where the flow channels are made narrow immediately before the projections 4. After that, turbulent flows are brought about by the refrigerant being brought into collision with the projections 4, and the velocity of the refrigerant is locally accelerated, and at the same time, the refrigerant is mixed by vortex motions, wherein transfer of the heat quantity from the heat radiating plates to the refrigerant is accelerated. Thus, by increasing the mixing effect of the refrigerant by means of the projections, the heat can be efficiently taken away from the heat radiating plates contacted with the flow channels 2. In addition, the separation rod 5 assumes a role of rectifying the refrigerant flowing in the left and right flow channels. The refrigerant passed through the area where the projections 4 are formed is rectified by the separation rod 5 and is discharged from the opening portion 3b following the flow channels 2. In the heat sink according to the embodiment, the opening portion 3a is made into an inlet port and the opening portion 3b is made into an outlet port. However, the heat sink is not limited thereto, wherein the opening portion 3b may be made into an inlet port and the opening portion 3a may be made into an outlet port.

In the heat sink according to the present embodiment, the flow channel 2 is formed so as to be divided into the left side and the right side from the opening portion 3b, and the separation rod 5 is provided, which prevents that the left and right flow channels are brought into confluence with each other at the lower area of the heating element jointed portion 7 which is a thermal connection area with the heating element 8. By employing such a water channel structure, although the temperature of the refrigerant divided into the left side and the right side rises when the refrigerant passes through the heating element jointed area 7, the refrigerant is discharged from the opening portion 3b without being mixed. Therefore, the heat conversion efficiency of the refrigerant in the heat sink can be improved, and the cooling capacity can be improved.

Also, in the heat sink according to the present embodiment, a plurality of projections 4 are formed in a flow channel corresponding to the lower area of the heating element jointed area 7, and the sectional shape of the projections 4 are widened toward the end, wherein the agitating effect in the up and down direction of the refrigerant flowing through the flow channels can be accelerated, and the cooling capacity can also be improved. Since the tip end portions of the projections widening toward the end are brought into contact with the wall surface of the flow channels, it is possible to prevent the velocity from being lowered due to a decrease in the sectional area of the flow channels, and the agitating effect in the up and down directions of the flow channels can be further accelerated to increase the cooling effect. Further, since the heat sink is constructed so that the refrigerant is flown into the area where the projections are formed, once the sectional area of the flow channels following the hole into which the refrigerant is injected is made narrow, it is possible to accelerate the velocity of the refrigerant, wherein the cooling effect can be improved.

Further, in the heat sink according to the embodiment, since the flow channels 2 formed on the first heat radiating plate 1 are constructed as described above, it is possible to produce a heat sink only by joining two heat radiating plates each other, namely joining the first heat radiating plate 1, on which the flow channels 2 are formed, and the second heat radiating plate 6, which is plate-shaped. Therefore, the joining processes can be reduced in comparison with prior art process for producing heat sinks in which flow channels are formed in a plurality of layers, and the production costs can be reduced. In addition, since the number of joining points can be reduced in comparison with the prior art heat sinks, a possibility of water leakage due to defective joining can be lowered, and the reliability thereof can be improved.

Further, since turbulent flows of a refrigerant, which does not pertain to cooling of a heating element, increases the pressure loss, and reduces the velocity, it is necessary that such turbulent flows are reduced as much as possible. Therefore, in the heat sink according to the present embodiment, the sectional structure of the flow channels is not rectangular, but is shaped so as to be enclosed by a curved line. As a result, it is possible to suppress turbulent flows at bent portions. The effect can be obtained if only a part of the flow channels is enclosed by a curved line. Further, if the flow channels are formed by isotropic etching of metal, the heat sink having the flow channels, a part of which is made U-shaped and curved. It is possible to form flow channels 2 whose section is semicircular, by joining a plate-shaped heat radiating plate 6 to the heat radiating plate 1, wherein turbulent flows produced in the bent portion of the flow channels 2 can be suppressed, and it is possible to suppress unnecessary pressure losses. Further, since the pressure loss of the flow channels is low, load applied onto the jointed boundary surface is reduced, and the long-term reliability of the heat sink for hydraulic pressure resistance can be increased.

Still further, by the above-described chemical etching, it becomes possible to inexpensively form the projections 4 each having a shape, whose section in the vertical direction to the heat radiating plate 1 and the heat radiating plate 6 widens toward the end, and the flow channels 2 in a short time. By the projections 4 being formed so as to have such a shape, the heat radiating plate 1 and the heat radiating plate 6 can be jointed together without etching the tip ends thereof.

Also, the heat sink according to the embodiment is effective for heating elements other than a laser diode such as an electronic device employing, for example, a silicon semiconductor or a compound semiconductor. Further, a refrigerant other than water may be used as the refrigerant used in the heat sink according to the present embodiment, and this is the same with respect to the following embodiments.

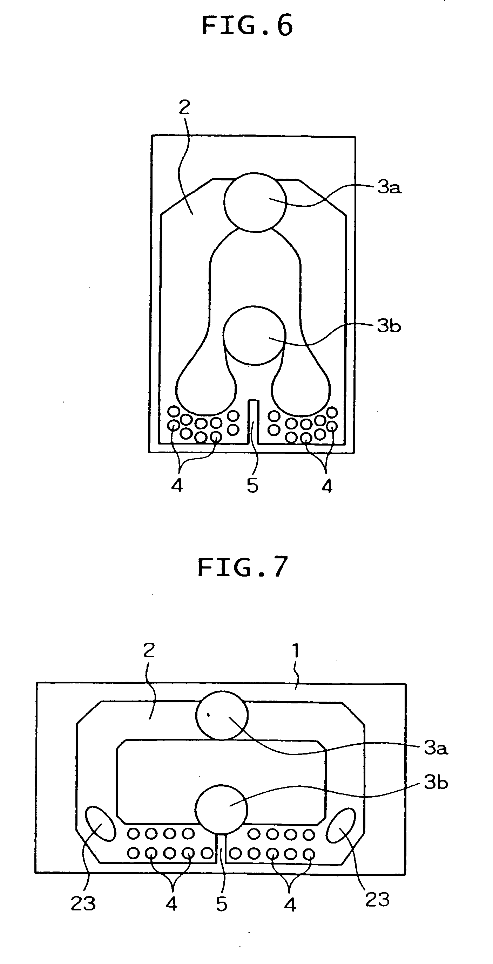

The position, orientation and quantity of the projections 4 according to the embodiment are not limited to such a construction as shown in FIG. 1(a), but may be adequately selected in compliance with the shape, production method and required characteristics, etc., of the flow channels 2. For example, the projections 4 may be shaped as described below. FIG. 6 through FIG. 9 are plan views showing modified versions of the shape of the flow channels in a heat sink according to the present embodiment. The first modified version shown in FIG. 6 is such that the width of flow channels in an area where the projections 4 are formed is widened, and further the projections 4 are formed in two rows each of which is composed of five projections. With such a shape of the flow channels, it is possible to efficiently cool off a heating element whose area is large.

In addition, the second modified version shown in FIG. 7 is such that the projections 4 are disposed at the long side of the heat radiating plate. In the modified version, projections 23 to increase the velocity are provided separately from the projections 4 to accelerate turbulent flows. Also, the flow channels 2 in the modified version are completely separated by the separation rod 5 from each other, wherein a refrigerant injected from an inlet port is discharged from the outlet port without making any confluence in the flow channels 2. By employing such a shape for the flow channels, a long heating element can be handled.

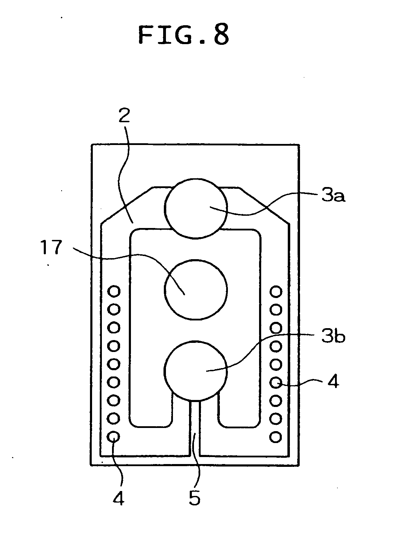

Further, the third modified version shown in FIG. 8 is formed so that projections 4 are disposed so as to become parallel to the lengthwise direction of the heat radiating plate in the left and right flow channels, respectively. By employing such a shape for the flow channels, it is possible to joint two heating elements to the heat sink, one of which is joined at one of long side of the heat sink and the other of which is joined at the other long side thereof. At this time, the capacity of cooling off a single heating element is made half the capacity in a case where a single heating element is jointed at the short side. This is effective in a case where light of a laser diode is outputted in the left and right directions.

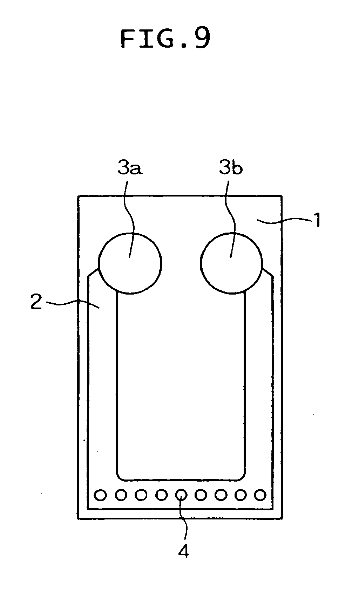

The fourth modified version shown in FIG. 9 is such that the flow channel 2 is formed to be U-shaped, wherein the opening portion 3a is formed at one end thereof, and the opening portion 3b is formed at the other end thereof. Since this type has a simpler structure than the types in which the left and right two flow channels are formed, completely the same effect can be obtained even if either one of the opening portions 3a and 3b is made into an inlet port.

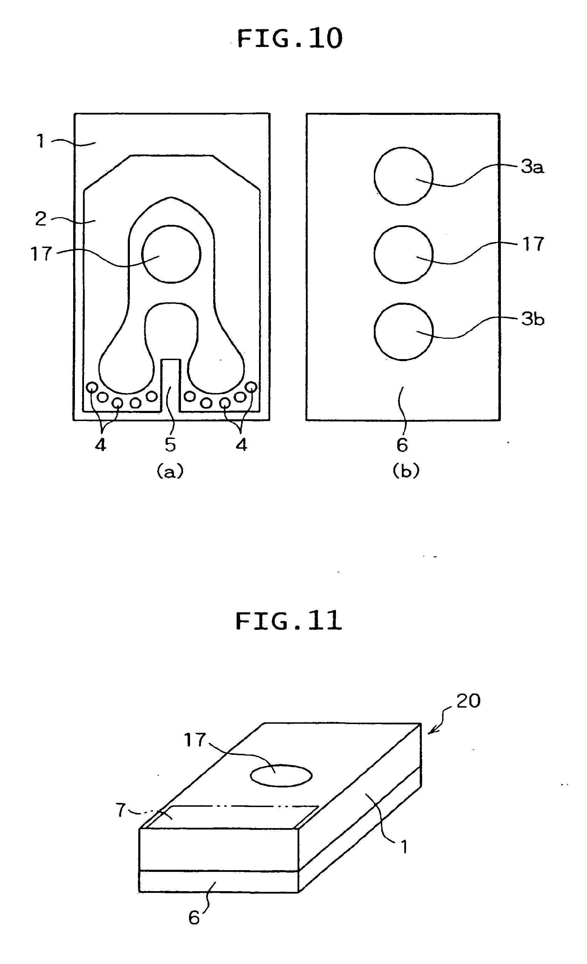

Next, a description is given of a heat sink according to a second embodiment of the present invention. FIG. 10(a) is a plan view showing the first heat radiating plate of a heat sink according to the second embodiment of the present invention, and FIG. 10(b) is a plan view showing the second heat radiating plate. In addition, FIG. 11 is a perspective view showing the second embodiment of the present invention. A heat sink according to the second embodiment of the present invention includes a heat radiating plate 1 having flow channels 2 formed therein as in first embodiment described above, and a plate-shaped heat radiating plate 6. As shown in FIGS. 10(a) and 10(b), projections 4 and a separation rod 5 are formed, as in the first embodiment described above, in the flow channels 2 formed in the first heat radiating plate 1. In the heat sink according to the present embodiment, flow channels are formed in the heat radiating plate 1 disposed at the upper part, and the cross section of the projections in the flow channels are shaped so as to become smaller from the upper part thereof toward the bottom thereof. Also, a through-hole 17 through which a screw to fix the heat sink on a base to supply a refrigerant is inserted is formed at the center part of the heat radiating plate 1 and the heat radiating plate 6. On the other hand, the opening portions 3a and 3b to inject and discharge a refrigerant are formed in the second heat radiating plate 6. Also, on the surfaces of the first heat radiating plate 1 and the second heat radiating plate 6, a plated layer of 5µm or so in thickness is formed. The plated layer is formed on the entire surface of the heat radiating plate including the flow channels 2, projections 4 and separation rod 5. Further, in the heat sink according to the present embodiment, the first heat radiating plate is jointed onto the upper part of the second heat radiating plate 6 as shown in FIG. 11, and a heating element jointed portion 7 is provided on the first heat radiating plate 1.

In a prior art heat sink, where copper or a copper alloy is used for the material of heat radiating plates and water is used as a refrigerant, there was a problem in that rust occurs in the heat sink. Therefore, in the heat sink according to the present embodiment, a plated layer is provided on the surface of the flow channels 2, and with the plated layer, the heat radiating plates are prevented from being rusted. It is preferable that, for example, the material of the plated layer is nickel where the material of the heat radiating plates is made of copper or a copper alloy. In particular, it is preferable that the nickel content in the plated layer is 70wt% or more. If a metal other than nickel is used for the plated layer, there is a fear that corrosion is accelerated due to an effect of galvanic current with the copper. Since a difference in the ionizing tendency between copper and nickel is slight, no influence is given by the galvanic current, and since nickel is hard, it has excellent durability. Further, where the heat sink is used as a part of an electrode of a laser module, large current flows in the entirety of the heat sink. In this case, if there exists boundaries of different metals, corrosion is generated. Therefore, it is preferable that a plated layer is formed by a metal whose ionizing tendency is close to that of the material of the heat sink. For example, where the heat sink is made of copper or a copper alloy, it is preferable that the material of the plated layer is nickel.

A copper oxide layer may be formed instead of the plated layer. Although oxidization of copper is a kind of corrosion, an oxide layer formed on the surface of the copper becomes possible to suppress further inner oxidation in water, wherein corrosion can be prevented.

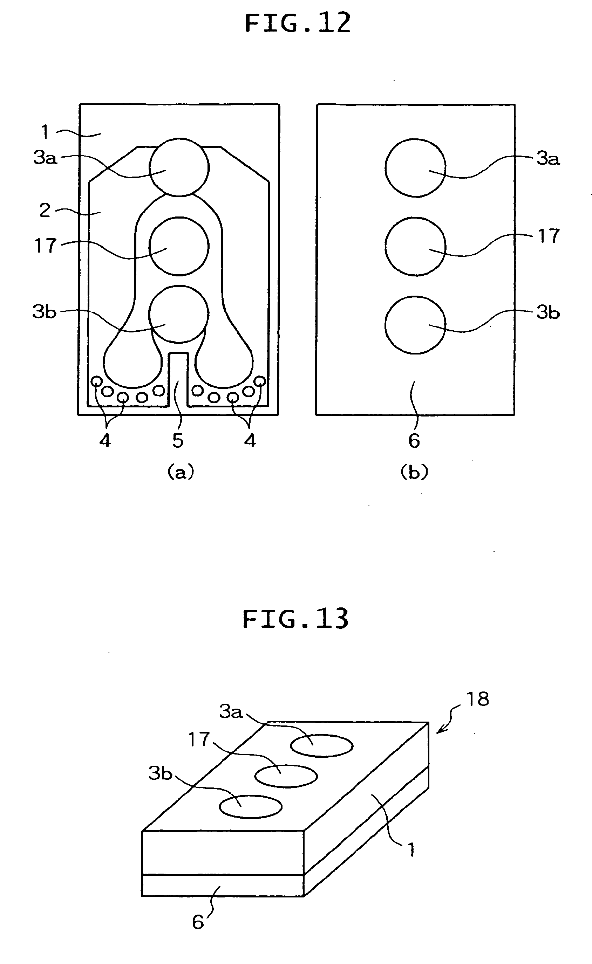

Next, a description is given of a heat sink according to a third embodiment of the present invention. FIG. 12(a) is a plan view showing the first heat radiating plate of a heat sink according to the third embodiment of the present invention, and FIG. 12(b) is a plan view showing the second heat radiating plate. FIG. 13 is a perspective view showing the third embodiment of the present invention. A heat sink according to the third embodiment of the present invention includes, as shown in FIGS. 12(a) and 12(b), the first heat radiating plate 1 having the flow channels 2, projections 4 and separation rod 5 formed therein as in the second embodiment described above, and the second heat radiating plate 6 which is plate-shaped. A through-hole 17 for fixing the heat radiating plates 1 and 6 on a base to supply a refrigerant to the heat sink is formed at the center part of the first heat radiating plate 1 and the second heat radiating plate 6. Also, a nickel-plated layer is formed on the inner surface of the flow channels 2. Furthermore, in the heat sink according to the present embodiment, an opening portion 3a and an opening portion 3b are formed at both the heat radiating plate 1 and heat radiating plate 6 in order to inject and discharge a refrigerant. These opening portions 3a and 3b are made into through-holes when a heat sink is brought about by joining the first heat radiating plate 1 and the heat radiating plate 6 together.

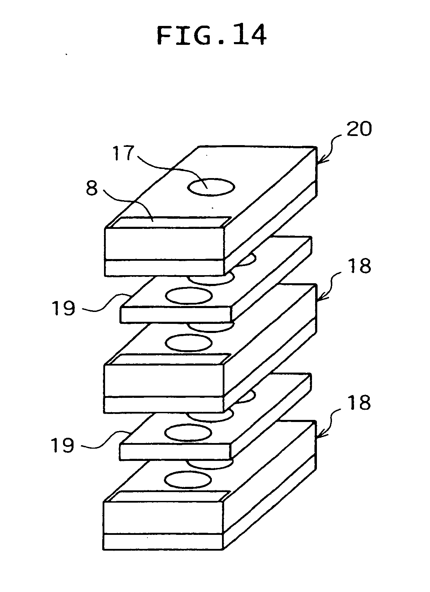

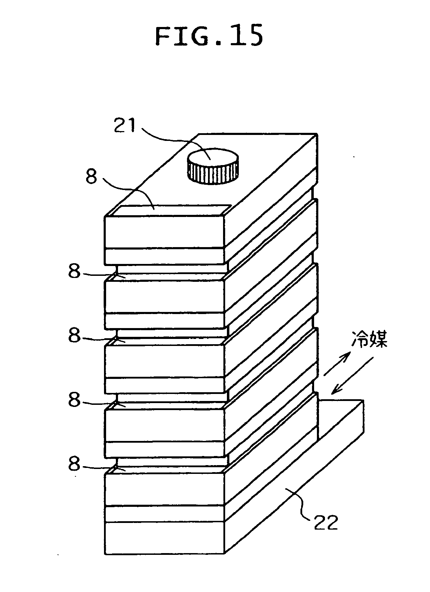

Next, a description is given of operations of the heat sink according to the present embodiment. The heat sink according to the embodiment is used in a stacked state. FIG. 14 is a perspective view showing the configuration of the heat sink according to the present embodiment when the heat sinks are stacked, and FIG. 15 is a perspective view showing the configuration of the heat sinks according to the third embodiment of the present invention when the heat sinks are stacked in five layers. Where the heat sinks according to the present embodiment are stacked, a heat sink 20 having a structure shown in FIG. 11 is disposed on the extreme upper layer, and the heat sinks 18 shown in FIG. 13 are stacked on the second layer and subsequent layers. At this time, a spacer 19 having flow channels of a refrigerant and through-holes for fixing together is disposed between the respective heat sinks. Where the heat sinks are thus stacked in five layers, as shown in FIG. 15, a screw 21 to fix the heat sinks is inserted from the extreme upper heat sink 20 into the through-hole 17 and is fixed at a fixture 22 which supplies a refrigerant to the heat sink. The refrigerant supplied from the fixture 22 is supplied into respective heat sinks via one of the opening portion 3a or 3b which is continuous in the vertical direction, and thereafter is discharged via the other of the opening portions 3a and 3b and is discharged from the fixture 22.

In the heat sinks according to the present embodiment, the opening portions 3a and 3b are formed at both the first heat radiating plate 1 and the second heat radiating plate 6 and are passed through the heat sinks, whereby a plurality of heat sinks are stacked, and refrigerant can be circulated in a plurality of heat sinks. Such a stack-type heat sink is fixed at the base, to which a laser diode is jointed, and having flow channels for supplying a refrigerant, whereby the refrigerant is flown into these heat sinks. Further, an electrode for oscillating the laser diode is connected to the laser diode and the heat sinks, wherein a current is flown by utilizing the heat sinks as a part of the electrode, thereby causing the laser diode to oscillate. The heat sink according to the present embodiment has high cooling capacity, and since there are few jointed parts, the worry of a refrigerant leaking out is remarkably reduced. Therefore, it is possible to propose a laser module having high reliability at low cost.

The heat sinks according to the present embodiment are, respectively, made of two metal sheets, and it is possible that the thickness thereof is reduced to 1.0mm where the cooling capacity is 0.4°C/W. The heat sinks can be made thinner than a prior art heat sink of a two-stage structure, and it is possible to obtain a cooling capacity equivalent thereto. Therefore, in a case of producing a stack type laser module in which heat sinks having a laser diode array jointed thereto are stacked in the vertical or longitudinal direction, it is possible to make the height thereof in the longitudinal direction lower than in cases of using prior art heat sinks, and light outputted from the respective laser diode arrays can be easily led to a single optical fiber.

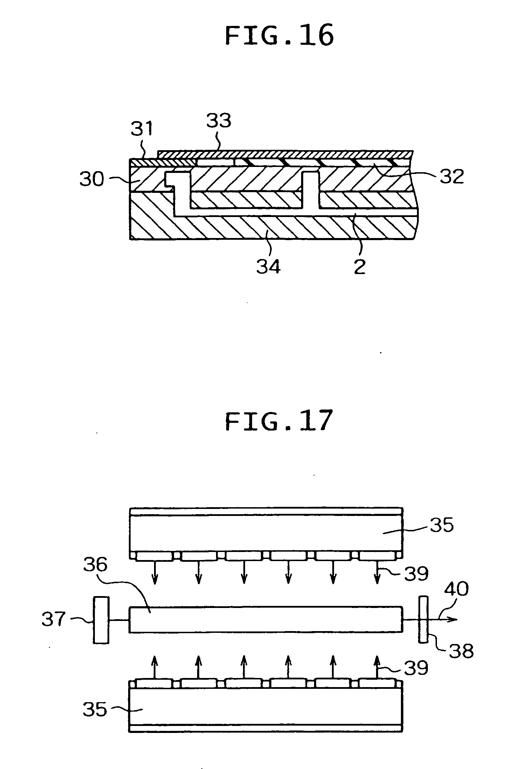

Next, a description is given of a laser module according to a fourth embodiment of the present invention. FIG. 16 is a sectional view showing a laser module in which heat sinks according to the second embodiment are employed. In a laser module according to the fourth embodiment of the present invention, a laser diode 31 is jointed onto the upper surface of a heat sink 30 having a structure similar to that of the second embodiment described above, and an upper electrode 33 is connected to the upper part of the laser diode 31. An insulation spacer 32 having almost the same thickness as that of the laser diode 31 is disposed between the upper electrode 33 and the heat sink 30.

Next, a description is given of operations of a laser module according to the present embodiment. In the laser module according to the present embodiment, a heat sink 30 is fixed on a base 34 for injecting and discharging a refrigerant, and the refrigerant is flown into the heat sink 30 via a flow channel 2 provided in the refrigerant injecting/discharging base 34. In the laser module according to the present embodiment, since the heat radiating plate composing the heat sink 30 is made of a material having conductivity, the heat sink 30 can be used as a lower electrode, wherein a current is flown into the upper electrode and the lower electrode, and a laser can be oscillated.

Because the heat sink according to the second embodiment is employed for the laser module according to the embodiment, there is no worry about water leakage, and since a nickel layer is provided on the surface of the flow channel, the ratio of corrosion generation is low, wherein, even if a running test is carried out for more than 100 million hours being the service life of a laser diode, the cooling capacity of the heat sink does not deteriorate. Further, since it becomes unnecessary to replace the module due to an inconvenience of the heat sink, it is possible to reduce maintenance costs thereof to a large extent.

Next, a description is given of a laser apparatus according to a fifth embodiment of the present invention. FIG. 17 is a schematic view showing the configuration of a laser apparatus according to the fifth embodiment of the present invention. A laser apparatus according to the fifth embodiment of the present invention employs a 6-series laser module 35, in which six laser modules according to the **fourth** embodiment are arranged, as an excitation light source of an Nd:YAG laser rod 36. The Nd:YAG laser rod 36 is disposed between a pair of laser modules 35. Also, a rear mirror 37 and an output mirror **38** are disposed backward and forward of the Nd:YAG laser rod 36. Further, FIG. 17 depicts a case where the Nd:YAG laser rod is excited from two directions. With the laser modules 35 according to the present embodiment, the Nd:YAG laser rod may be excited from three or more directions.

Next, a description is given of operations of the laser apparatus according to the present embodiment. The laser apparatus of the present embodiment is oscillated by laser light 39 from the laser module 35. The laser light 39 is absorbed by the Nd:YAG laser rod 36, and the light emitted from the Nd:YAG laser rod **36** is resonated by the rear mirror 37 and the output mirror 38 to cause Nd:YAG laser light 40 to be generated.

Since the laser apparatus according to the present embodiment employs a laser module, in which the heat sink according to the second embodiment described above is used, as an excitation light source, it becomes possible to obtain stabilized laser light for a longer period of time, and maintenance costs thereof can be reduced.

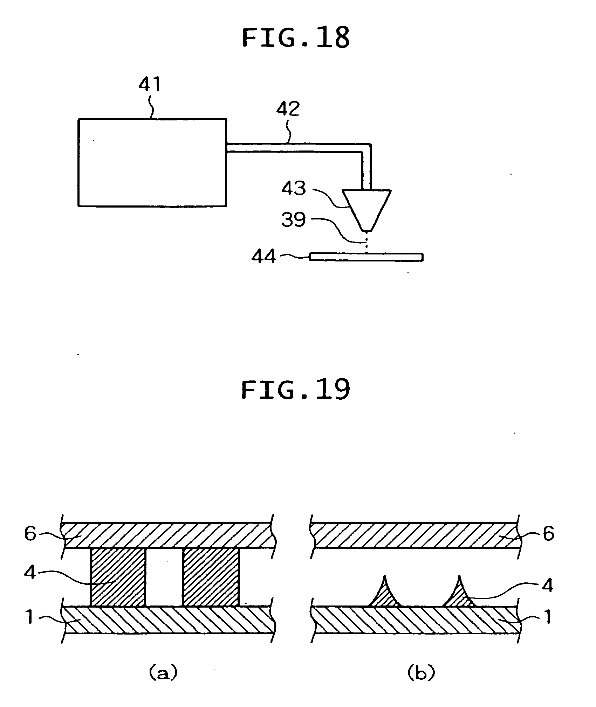

Next, a description is given of a laser processing apparatus according to a sixth embodiment. FIG. 18 is a schematic view showing the configuration of a laser processing apparatus incorporating a laser module in which a heat sink according to the first embodiment described above is employed. As shown in FIG. 18, a laser processing apparatus according to the sixth embodiment of the present invention once couples light, which is outputted from a laser apparatus 41, to a fiber 42, thereafter condenses the same by a lens 43, and irradiates the same onto a workpiece 44, thereby carrying out welding and cutting. The laser processing apparatus according to the present embodiment achieves a decrease in costs by employing the heat sinks according to the first embodiment described above, and the probability of trouble resulting from the heat sinks can be remarkably reduced. Therefore, it is possible to reduce the running costs and maintenance costs to a large extent.

Hereinafter, a description is given of the results of having evaluated the characteristics by comparison of the examples according to the present invention with comparative examples departing from the scope of the present invention.

First, a heat sink which is 25mm long, 11mm wide and 2.5mm thick, and has a structure similar to that of the first embodiment shown in FIG. 1 and FIG. 2 was manufactured as the first example of the present invention. In the example, a copper plate was used for the heat radiating plates, and a flow channel of 0.5mm deep was produced in the copper plate by chemical etching to make the first heat radiating plate. Subsequently, a laser diode array, in which the array length is 10mm, resonator length is 1.3mm, and thickness is 130µm, capable of outputting light of 808nm at 50W was jointed to the heating element jointed portion 7 of the heat sink as a heating element 8, and cooling water whose temperature 25°C was circulated as a refrigerant. And, the cooling capacity was investigated. At this time, the inlet port was made into the opening portion 3a, and the outlet port was made into the opening portion 3b. As a result, the thermal resistance was 0.25°C /W, and unevenness in wavelengths outputted from respective light emitting points of the laser diode array was within ±1nm. Also, the temperature of the jointed laser diode array was cooled within ±3°C, wherein capacity equivalent to or exceeding the capacity of the prior art heat sink having a stacked structure could be obtained. Further, a similar test was carried out with the inlet port and the outlet port replaced by each other, wherein a difference in the cooling capacity was within ±5°C. Still further, the heat sink according to the present example can be produced by forming the first heat radiating plate by means of etching a single copper plate, and joining the same with another copper plate. Therefore, it was possible to reduce the production costs to half or less the costs required for prior art heat sinks.

Also, a similar experiment was carried out while varying the size of the heat sink in a range of 15mm through 25mm long, 10mm through 12mm wide, and 1 through 3mm thick,
wherein the cooling efficiencies conform with each other within ±10% where the length and width were varied. On the other hand, where the thickness was 3mm, thermal resistance of 0.20°C/W was obtained. The value of the thermal resistance increases in line with thinning of the thickness of the copper plate being a heat radiating plate, and it was 0.30°C/W in a heat sink whose thickness is 1mm.

Next, as the second example of the present invention, a heat sink was produced, in which the shape, position and orientation of projections 4 were varied, and the cooling capacity was investigated. The heat sink according to the present example was made similar to the heat sink according to the first embodiment, which is shown in FIG. 1 and FIG. 2, excepting that the shapes of the projections 4 differ. First, heat sinks having projections whose shapes in section in the vertical direction with respect to the first heat radiating plate 1 and the second heat radiating plate 6 are a shape widening toward the end (Refer to FIG. 4) as like in the first embodiment described above, a columnar shape (Refer to FIG. 19(a)), and a shape 16 not contacted with a plane plate (Refer to FIG. 19(b)) were produced, and the cooling capacity was investigated. As a result, the cooling capacity of the heat sink, having projections which are columnar-shaped and widen toward the end, shown in FIG. 4 was higher by 10% or more than that of the heat sinks having projections having other shapes. Next, with respect to the heat sinks having projections whose shape in section in the direction parallel to the second heat radiating plate 1 and the first heat radiating plate 2 is circular as shown in FIG. 5(a), elliptical as shown in FIG. 5(b), and streamline-shaped as shown in FIG. 5(c), the pressure loss was 0.02MPa or less in cases where the orientation of the projections was adjusted so as for the pressure loss to be minimized with respect to flows of a refrigerant flowing in the flow channels. And, the respective cooling capacities were 0.30°C/W or less, wherein heat sinks whose thermal conversion efficiency is equivalent to or exceeding that of the prior art heat sinks of the stacked structure were obtained.

Next, as the third example of the present invention, a heat sink having a size similar to the first example, the thickness of which is 2.5mm, was produced, and flow channels 0.15mm deep are provided on the second heat radiating plate with the same pattern as that of the flow channels 2 formed on the first heat radiating plate 1 as shown in **FIG. 23****,**
wherein the pressure loss could be reduced by 20%, and the flow amount was increased. Therefore, it was possible to lower the thermal resistance by 0.20°C/W or so.

Also, changes in the thermal resistance were investigated in a case where the quantity and size of the projections having a shape shown in FIG. 5B are varied. As a result, where the area occupied by the respective projections is the same on both the bottom surface and the upper surface of the flow channels, the cooling efficiency was further increased in the case of increasing the number of the projections than in the case of making the cross sectional area of the projections larger. Also, if the ratio of the area occupied by the respective projections to the entire area on the bottom surface or the upper surface of the flow channels exceeds 80%, the pressure loss was increased, and the cooling capacity was lowered. Further, if the ratio of the area occupied by the projections to the entire area on the bottom surface or the upper surface of the flow channels becomes 20% or less, only the cooling capacity which is equivalent to a case where no projection is provided was obtained.

Next, as the third example of the present invention, using a copper plate as the material of the heat radiating plates, a heat sink having a nickel-plated layer of 5µm in thickness formed on the surface of the flow channels 2, a heat sink having a gold-plated layer of 5µm in thickness formed on the surface of the flow channels 2, a heat sink having a nickel-plated layer of 5µm in thickness formed on the surface of the flow channels 2 and a gold-plated layer of 1µm in thickness formed on the nickel-plated layer, and a heat sink, not having a plated layer formed thereon, in which the surface of the flow channels is merely made of copper, were, respectively, produced in compliance with the structure similar to that of the first embodiment. As a corrosion-resisting test, after salt water whose temperature is 25°C was circulated into these heat sinks for 50 hours, the interior thereof was observed. As a result, the corroded area of the heat sink having only a nickel-plated layer formed thereon was one-fifth the corroded area of the heat sink in which the surface of the flow channels 2 is merely made of copper, one-third the corroded area of the heat sink having a gold-plated layer formed thereon, and one-half the corroded area of the heat sink having a gold-plated layer on a nickel-plated layer.

Also, a heat sink having a copper oxide layer formed of 100nm thickness instead of the nickel-plated layer was prepared, and changes in the pressure loss of the flow channels were measured for a long period of time while flowing cooling water. Further, the time for which corrosion grows and a change in the pressure loss is commenced was measured. The time of the heat sink having a copper oxide layer is equivalent to that of the heat sink having a nickel-plated layer, which is approximately 3000 hours. In the heat sink in which the surface of the flow channels is merely made of copper, an increase in the pressure loss was commenced in approximately 1500 hours, wherein the copper oxide layer is equivalent to the nickel-plated layer and has greater corrosion resistance by two times than in the case of only copper.

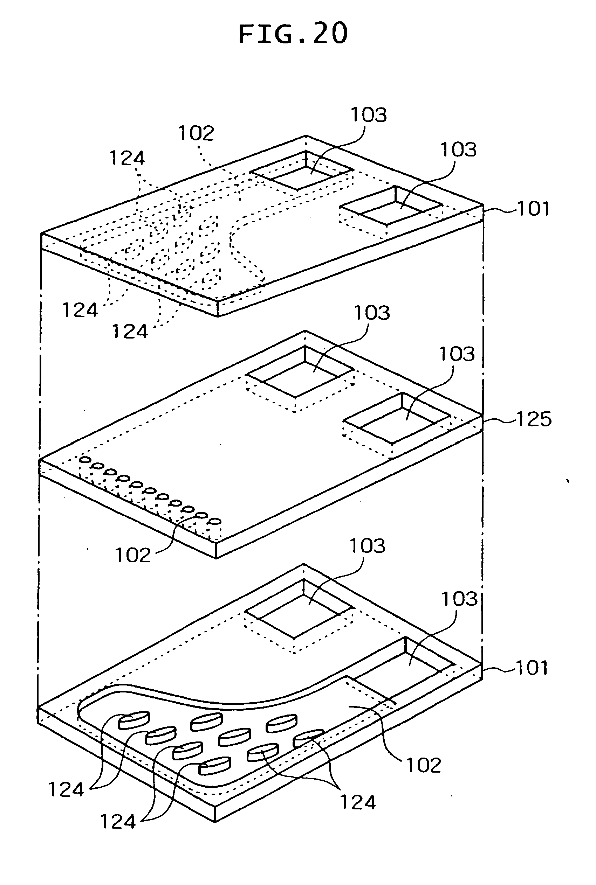

Next, a prior art heat sink, proposed by Patent Document 7 described above, in which flow channels are two-layered was produced as the first comparative example of the present invention. FIG. 20 is a perspective view showing the prior art heat sink proposed by Patent Document 7. The heat sink is formed of three heat radiating plates in total, consisting of two heat radiating plates 101 having flow channels formed therein, which are located up and down, and one heat radiating plate 125 having flow channels formed in the intermediate layer. A refrigerant injected from the opening portion 103 into the flow channels 102 are dispersed by fins 124 for rectifying the refrigerant, is thereafter coupled in the flow channels in the longitudinal direction of the intermediate layer, and is discharged from an opening after having been rectified again by the fins. In the heat sink of this structure, since the flow channel of the intermediate layer is narrow, the pressure loss is large, and since the width of the flow channel is widened, the velocity is lowered. Further, since it is necessary to form flow channels in all three heat radiating plates, the production costs thereof are expensive. Therefore, since the heat sink according to the present invention has less pressure loss and faster velocity than the first comparative example, the cooling capacity thereof is superior to the first comparative example, wherein the heat sink according to the present invention is advantageous in view of costs and reliability.

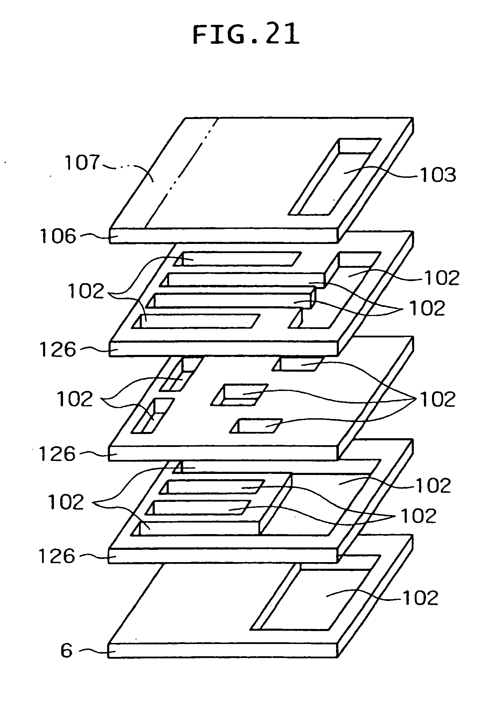

Next, a prior art heat sink, in which the flow channels are two-layered, proposed by Patent Document 8 described above was produced as the second comparative example of the present invention. FIG. 21 is a perspective view showing the structure of the prior art heat sink proposed by Patent Document 8. The heat sink is formed of five heat radiating plates in total, consisting of flat heat radiating plates 101 each having an opening portion formed therein, which are one heat radiating plate for each of the upper and lower sides, and three heat radiating plates 126 having penetrated flow channels formed as intermediate layers. A refrigerant injected from the opening portion 103 into the flow channels 102 is flown in the flow channels formed between the heat radiating plates of the intermediate layers in the up and down directions and in the left and right directions, and is thereafter discharged from the opening 103 opposed to the injection side. Since, in the heat sink, it is necessary to use five heat radiating plates which are penetrated, the production costs thereof are increased, and there are many jointed phase boundaries between the heat radiating plates. Therefore, there remains a problem in reliability, for example, liquid leakage, etc. In addition, although the effect of cooling the entirety of the heat sink is high, it is difficult to intensively cool off only the lower part of the portion 107 to which a heating element is jointed. Therefore, the heat sink according to the present invention is further excellent and advantageous in view of costs, reliability and cooling capacity in comparison with the second comparative example.

Next, a prior art heat sink having flow channels formed on the same flat plane, which was proposed by Patent Document 5 described above, was produced as the third comparative example of the present invention. FIG. 22(a) is a sectional view showing the structure of the prior art heat sink proposed by Patent Document 5, and FIG. 22(b) is a plan view thereof. In the heat sink are formed two flow channels 102 each having a pair of independent inlet ports and outlet ports, and two bent flow channels 127 opposing each other at an area adjusted to the heating element jointed portion 107 where a heating element 108 is jointed. A refrigerant injected from the inlet port is discharged after passing through the bent portions formed in the respective flow channels. The structure of the heat sink is simple. However, the pressure loss is large at the bent portion, and since it is necessary to separately carry out injection of the refrigerant into two flow channels and discharge thereof from the two flow channels, the base for supplying the refrigerant is complicated. Accordingly, the heat sink according to the present invention has less pressure loss and a further excellent cooling efficiency.

As described in detail above, according to the present invention, since projections are provided in the flow channels formed in the heat radiating plate, turbulent flows are brought about in the refrigerant flowing in the flow channels, mixture is carried out by vortex motions of the refrigerant, and transfer efficiency of the heat quantity from the heat radiating plates to the refrigerant can be improved, wherein the cooling efficiency can be increased. In addition, since the projections are shaped so that the cross sectional shape is made narrower upward from the bottom surface of the flow channels, or downward from the upper surface, the refrigerant is agitated in the vertical direction, and the cooling efficiency can be improved. By shaping the flow channels as described above, it is possible to achieve flow channels of a single-layered structure, which have a cooling capacity equivalent to or exceeding the cooling capacity of the prior art flow channels of a two-layered structure, and it is possible to construct a heat sink by a heat radiating plate, in which flow channels are formed, and a plate-shaped heat radiating plate. Thereby, the number of jointed points in the heat sink can be reduced to increase the reliability, and the production costs thereof can be further lowered.

### Industrial Applicability

The present invention is advantageous as a heat sink for efficiently cooling off a high-output laser.

## Claims

1. A heat sink constructed by stacking two heat radiating plates (1, 6), in which one heat radiating plate (1) includes a refrigerant flow channel (2) composed of a recess portion or a groove formed on an overlapping plane with the other heat radiating plate and a singular or a plurality of projections (4) provided so as to be dispersed in a specified area of the refrigerant flow channel, at least one of the two heat radiating plates is provided with a pair of openings (3a, 3b) that become an inlet port of a refrigerant and an outlet port thereof, the specified area is provided at a position adjusted to an area in which a heating element to be cooled is thermally connected, each of said projections (4) as a shape in which a part of the outer edge of the shape of the cross section is formed of a curved line, **characterised in that** the projections (4) have a shape of a cross section that becomes smaller and smaller upward from the bottom surface of the flow channels, or **in that** the projections (4) have a shape of a cross section that becomes smaller and smaller downward from the upper surface of the flow channels.

2. The heat sink according to Claim 1, wherein the cross-sectional shape of the projections (4) is circular, elliptical or streamline-shaped to the flows of the refrigerant.

3. The heat sink according to Claim 1, or 2, wherein the projections (4) are brought into contact with the other heat radiating plate.

4. The heat sink according to Claim 1, 2 or 3, wherein one heat radiating plate has a pair of flow channels (2) shaped so that the refrigerant introduced from the inlet port is discharged from the outlet port after being separated into the respective flow channels and passed through the specified area, and the specified area is provided with a separation member (5) for preventing the refrigerant from being brought into confluence.

5. The heat sink according to Claim 1, 2, 3, or 4, wherein the flow channels have the first area contacted with the inlet port and the second area existing between the first area and the specified area, and the width of the second area is narrower than that of the first area.

6. The heat sink according to Claim 1, 2, 3, 4, or 5, wherein at least a part of the inner surface of the flow channels is formed of a curved surface.

7. (Amended) The heat sink according to Claim 1, 2, 3, 4, 5, or 6, wherein a refrigerant flow channel of a pattern adjusted to at least a part of the pattern of the refrigerant flow channel formed in one heat radiating plate (1) is formed in the other heat radiating plate (6).

8. (Amended) The heat sink according to Claim 1, 2, 3, 4, 5, 6, or 7, wherein the flow channels (2) are formed by a chemical etching method.

9. (Amended) The heat sink according to Claim 1, 2, 3, 4, 5, 6, 7, or 8, wherein the heat radiating plates (1, 6) are made of copper or a copper alloy, and a nickel-contained layer including nickel by 70 wt% or more is formed on the surface with which the refrigerant is contacted in the flow channels.

10. The heat sink according to Claim 9, wherein the nickel-contained layer is formed by a plating method.

11. The heat sink according to Claim 1, 2, 3, 4, 5, 6, 7, or 8, wherein the heat radiating plate is made of copper or a copper alloy, and an oxide layer whose thickness is 50nm or more is formed on the surface with which the refrigerant is contacted in the flow channels.

12. The heat sink according to Claim 1, 2, 3, 4, 5, 6, 7, 8, 9, 10, or 11,, for which the heating element is a laser diode.

13. A laser module including a heat sink according to Claims 1, to 12, a setting fixture fixed to said heat sink, and a laser diode fixed on one heat radiating plate of the heat sink.

14. The laser module according to Claim 13, having a singular or a plurality of heat sinks, in which a through-hole penetrating said singular or said plurality of heat sinks is provided at an area where no flow channel is formed in the heat sinks, and the heat sink is fixed at the setting fixture by a screw inserted into the through-hole being screwed in the setting fixture.

15. The laser module according to Claim 13 or 14, wherein flow channels for supplying a refrigerant into the heat sinks are provided in the setting fixture.

16. A laser apparatus including a laser module according to any one of Claims 13 through 15, and a laser rod excited by laser light oscillated by the laser module, to oscillate laser light.

17. A laser processing apparatus including a laser module according to any one of Claims 13 through 15.

18. A laser processing apparatus including a laser apparatus according to Claim 16.

## Patentansprüche

1. Wärmesenke, die durch Stapeln zweier Wärmestrahlplatten (1, 6) aufgebaut ist, wobei eine Wärmestrahlplatte (1) einen Kältemittel-Flusskanal (2) aufweist, der aus einem Rücksprungbereich oder einer Nut aufgebaut ist, die in einer überlappenden Ebene mit der anderen Wärmestrahlplatte ausgebildet ist, und einer einzelnen oder einer Anzahl von Vorsprüngen (4), die so vorgesehen sind, dass sie in einem bestimmten Bereich des Kältemittel-Flusskanals verteilt sind, wobei zumindest eine der beiden Wärmestrahlplatten mit einem Paar Öffnungen (3a, 3b) versehen ist, die zu einem Einlass für ein Kältemittel und einem Auslass für dieses werden, wobei der bestimmte Bereich in einer Position vorgesehen ist, die zu einem Bereich eingestellt ist, in dem ein Wärmeelement, das zu kühlen ist, thermisch verbunden ist, wobei jeder der Vorsprünge (4) eine Form aufweist, bei der ein Teil der Außenkante in Form des Querschnitts in einer gekrümmten Linie ausgebildet ist, **dadurch gekennzeichnet, dass** die Vorsprünge (4) eine Form eines Querschnittes aufweisen, der nach oben von der Bodenfläche des Flusskanals kleiner und kleiner wird, und dass die Vorsprünge (4) eine Form eines Querschnitts aufweisen, der nach unten von der oberen Fläche des Flusskanals kleiner und kleiner wird.

2. Wärmesenke nach Anspruch 1, wobei die Querschnittsform der Vorsprünge (4) kreisförmig, elliptisch oder stromlinienförmig zu dem Fluss des Kältemittels ist.

3. Wärmesenke nach Anspruch 1 oder 2, wobei die Vorsprünge (4) in Kontakt mit der anderen Wärmestrahlplatte gebracht werden.

4. Wärmesenke nach Anspruch 1, 2 oder 3, wobei eine Wärmestrahlplatte ein Paar Flusskanäle (2) aufweist, die so geformt sind, dass das von dem Einlass eingeleitete Kältemittel von dem Auslass abgegeben wird, nach dem es in die jeweiligen Flusskanäle aufgetrennt wurde und den bestimmten Bereich passiert hat, und wobei der bestimmte Bereich mit einem Trennelement (5) versehen ist zum Verhindern, dass das Kältemittel zum Zusammenfluss gebracht wird.

5. Wärmesenke nach Anspruch 1, 2, 3 oder 4, wobei die Flusskanäle einen ersten Bereich aufweisen, der mit dem Einlass in Verbindung steht, und einen zweiten Bereich, der zwischen dem ersten Bereich und dem bestimmten Bereich existiert, wobei die Breite des zweiten Bereichs schmaler ist als die des ersten Bereichs.

6. Wärmesenke nach Anspruch 1, 2, 3, 4 oder 5, wobei zumindest ein Teil der Innenfläche der Flusskanäle mit einer gekrümmten Oberfläche ausgebildet ist.

7. Wärmesenke nach Anspruch 1, 2, 3, 4, 5 oder 6, wobei ein Kältemittel-Flusskanal in einem Muster, das zumindest zu einem Teil des Musters des Kältemittel-Flusskanals, der in der einen Wärmestrahlplatte (1) ausgebildet ist, in der anderen Wärmestrahlplatte (6) ausgebildet ist.

8. Wärmesenke nach Anspruch 1, 2, 3, 4, 5, 6 oder 7, wobei die Flusskanäle (2) durch ein chemisches Ätzverfahren gebildet sind.

9. Wärmesenke nach Anspruch 1, 2, 3, 4, 5, 6, 7 oder 8, wobei die Wärmestrahlplatten (1, 6) aus Kupfer oder einer Kupferlegierung gefertigt sind und wobei eine Nickel enthaltende Schicht, die Nickel zu 70 Gewichtsprozent oder mehr enthält, auf der Oberfläche, die von dem Kältemittel kontaktiert wird, in den Flusskanälen ausgebildet ist.

10. Wärmesenke nach Anspruch 9, wobei die Nickel enthaltende Schicht durch ein Plattierungsverfahren gebildet ist.

11. Wärmesenke nach Anspruch 1, 2, 3, 4, 5, 6, 7 oder 8, wobei die Wärmestrahlplatte aus Kupfer oder einer Kupferlegierung gefertigt ist und eine Oxidschicht, deren Dicke 50nm oder mehr beträgt, auf der Oberfläche, die mit dem Kältemittel in Kontakt steht, in den Flusskanälen ausgebildet ist.

12. Wärmesenke nach Anspruch 1, 2, 3, 4, 5, 6, 7, 8, 9, 10 oder 11, wobei das Wärmeelement eine Laserdiode ist.

13. Lasermodul mit einer Wärmesenke nach einem der Ansprüche 1 bis 12, ein Montagefitting, das mit der Wärmesenkung verbunden ist, und einer Laserdiode, die auf einer Wärmestrahlplatte der Wärmesenke befestigt ist.

14. Lasermodul nach Anspruch 13 mit einer einzelnen oder einer Anzahl von Wärmesenken, wobei ein Durchgangsloch, das durch die einzelne oder die Anzahl von Wärmesenken durchtritt in einem Bereich vorgesehen ist, in dem kein Flusskanal in den Wärmesenken ausgebildet ist, und wobei die Wärmesenke an dem Fitting durch eine Schraube befestigt ist, die in das Durchgangsloch eingebracht und in das Fitting eingeschraubt ist.

15. Lasermodul nach Anspruch 13 oder 14, wobei Flusskanäle zum Zuleiten eines Kältemittels in die Wärmesenken in der Befestigungsvorrichtung vorgesehen sind.

16. Lasergerät mit einem Lasermodul nach einem der Ansprüche 13 bis 15 und einem Laserstab, der durch Laserlicht, das in dem Lasermodul oszilliert, zum Schwingen des Laserlichts angeregt wird.

17. Laserbearbeitungsgerät mit einem Lasermodul nach einem der Ansprüche 13 bis 15.

18. Laserbearbeitungsgerät mit einem Lasergerät nach Anspruch 16.

## Revendications

1. Dissipateur thermique construit en empilant deux plaques de rayonnement de chaleur (1, 6), dans lequel une plaque de rayonnement de chaleur (1) comprend un canal d'écoulement de réfrigérant (2) composé d'une partie creuse ou d'une cannelure formée sur un plan se chevauchant avec l'autre plaque de rayonnement de chaleur et une seule projection ou plusieurs projections (4) étant ménagées de façon à être dispersées dans une zone spécifiée du canal d'écoulement de réfrigérant, au moins une des deux plaques de rayonnement de chaleur est dotée d'une paire d'ouvertures (3a, 3b) qui deviennent un orifice d'entrée d'un réfrigérant et un orifice de sortie de celui-ci, la zone spécifiée est ménagée dans une position ajustée à une zone où un élément chauffant à refroidir est thermiquement raccordé, chacune desdites projections (4) a une forme dans laquelle une partie du bord extérieur de la forme en coupe transversale est formée d'une ligne courbe, **caractérisé en ce que** les projections (4) ont une forme en coupe transversale qui se rétrécit vers le haut depuis la surface inférieure des canaux d'écoulement ou **en ce que** les projections (4) ont une forme en coupe transversale qui rétrécit vers le bas depuis la surface supérieure des canaux d'écoulement.

2. Dissipateur thermique selon la revendication 1, dans lequel la forme en coupe transversale des projections (4) est circulaire, elliptique ou aérodynamique par rapport aux écoulements du réfrigérant.

3. Dissipateur thermique selon la revendication 1 ou 2, dans lequel les projections (4) sont mises en contact avec l'autre plaque de rayonnement de chaleur.

4. Dissipateur thermique selon la revendication 1, 2 ou 3, dans lequel une plaque de rayonnement de chaleur dispose d'une paire de canaux d'écoulement (2) façonnés, de sorte que le réfrigérant introduit par l'orifice d'entrée soit déchargé par l'orifice de sortie, après avoir été séparé dans les canaux d'écoulement respectifs et passé à travers la zone spécifiée, et la zone spécifiée est dotée d'un élément de séparation (5) pour empêcher le réfrigérant d'être mis en confluence.

5. Dissipateur thermique selon la revendication 1, 2, 3 ou 4, dans lequel les canaux d'écoulement ont la première zone en contact avec l'orifice d'entrée et la seconde zone existant entre la première zone et la zone spécifiée et la largeur de la seconde zone est plus étroite que celle de la première zone.

6. Dissipateur thermique selon la revendication 1, 2, 3, 4 ou 5, dans lequel au moins une partie de la surface interne des canaux d'écoulement est dotée d'une surface incurvée.

7. Dissipateur thermique selon la revendication 1, 2, 3, 4, 5 ou 6 dans lequel un canal d'écoulement de réfrigérant d'un modèle ajusté à au moins une partie du modèle du canal d'écoulement de réfrigérant formé dans une plaque de rayonnement de chaleur (1) est formé dans l'autre plaque de rayonnement de chaleur (6).

8. Dissipateur thermique selon la revendication 1, 2, 3, 4, 5, 6 ou 7, dans lequel les canaux d'écoulement (2) sont réalisés par un procédé de décapage chimique.

9. Dissipateur thermique selon la revendication 1, 2, 3, 4, 5, 6, 7 ou 8, dans lequel les plaques de rayonnement de chaleur (1, 6) sont faites de cuivre ou d'un alliage de cuivre, et une couche contenant du nickel comprenant du nickel à 70 % en poids ou plus est formée sur la surface avec laquelle le réfrigérant est mis en contact dans les canaux d'écoulement.

10. Dissipateur thermique selon la revendication 9, dans lequel la couche contenant du nickel est formée par un procédé de plaquage.

11. Dissipateur thermique selon la revendication 1, 2, 3, 4, 5, 6, 7, ou 8 dans lequel la plaque de rayonnement de chaleur est faite de cuivre ou d'un alliage de cuivre, et une couche d'oxyde dont l'épaisseur est de 50 nm ou plus est formée sur la surface avec laquelle le réfrigérant est mis en contact dans les canaux d'écoulement.

12. Dissipateur thermique selon la revendication 1, 2, 3, 4, 5, 6, 7, 8, 9, 10, ou 11, pour lequel l'élément chauffant est une diode à laser.

13. Module laser comprenant un dissipateur thermique selon les revendications 1 à 12, un dispositif de réglage fixé audit dissipateur thermique et une diode à laser fixée sur une plaque de rayonnement de chaleur du dissipateur thermique.

14. Module laser selon la revendication 13, ayant un ou plusieurs dissipateurs thermiques, dans lequel un orifice passant pénétrant dans ledit ou lesdits dissipateurs thermiques est ménagé dans une surface où aucun canal d'écoulement n'est formé dans les dissipateurs thermiques, et le dissipateur thermique est fixé au dispositif de réglage par une vis insérée dans l'orifice passant vissé dans le dispositif de réglage.

15. Module laser selon la revendication 13 ou 14, dans lequel les canaux d'écoulement pour alimenter un réfrigérant dans les dissipateurs thermiques sont ménagés dans le dispositif de réglage.

16. Appareil laser comprenant un module laser selon l'une quelconque des revendications 13 à 15, et une tige à laser excitée par une lumière laser oscillée par le module laser, pour permettre l'oscillation de la lumière laser.

17. Appareil de traitement au laser comprenant un module laser selon l'une quelconque des revendications 13 à 15.

18. Appareil de traitement au laser comprenant un appareil au laser selon la revendication 16.
